(19) Europäisches Patentamt / European Patent Office / Office européen des brevets

(11) **EP 4 749 919 A1**

(12) **EUROPEAN PATENT APPLICATION**
published in accordance with Art. 153(4) EPC

(43) Date of publication:
**27.05.2026 Bulletin 2026/22**

(21) Application number: **24890278.5**

(22) Date of filing: **30.08.2024**

(51) International Patent Classification (IPC):
***H03H 9/17*** *(2006.01)*

(52) Cooperative Patent Classification (CPC):
**H03H 3/02; H03H 9/02; H03H 9/13; H03H 9/17; H03H 9/56; H03H 9/70**

(86) International application number:
**PCT/CN2024/116089**

(87) International publication number:
**WO 2025/102918 (22.05.2025 Gazette 2025/21)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.11.2023 CN 202311537342**

(71) Applicant: **Huawei Technologies Co., Ltd.
Shenzhen, Guangdong 518129 (CN)**

(72) Inventors:
 • ZHANG, Naiqing
  Shenzhen, Guangdong 518129 (CN)
 • PLESSKI, Viktor
  Shenzhen, Guangdong 518129 (CN)

(74) Representative: **Thun, Clemens
Mitscherlich PartmbB
Karlstraße 7
80333 München (DE)**

(54) **RESONATOR, FILTER AND ELECTRONIC DEVICE**

(57)  This application provides a resonator, a filter, and an electronic device, and relates to the field of resonator technologies. By using the resonator, an electromechanical coupling factor can be increased. The resonator may include a substrate, a first electrode, a piezoelectric transducer layer, and a plurality of second electrodes. The first electrode, the piezoelectric transducer layer, and the plurality of second electrodes are disposed on the substrate, the piezoelectric transducer layer has a first side and a second side, the plurality of second electrodes are located on the first side and arranged side by side in a first direction, the first electrode is located on the second side, the first side faces away from the substrate, and the second side faces toward the substrate. The piezoelectric transducer layer includes a first piezoelectric layer and a second piezoelectric layer that are stacked. The first piezoelectric layer has a first piezoelectric tensor component $e_{33}$, the second piezoelectric layer has a second piezoelectric tensor component $e_{33}$, and the first piezoelectric tensor component $e_{33}$ is opposite to the second piezoelectric tensor component $e_{33}$. The adjacent piezoelectric layers with opposite piezoelectric tensor components $e_{33}$ are used, so that the resonator can have large vibration, to increase the electromechanical coupling factor.

FIG. 5

## Description

This application claims priority to Chinese Patent Application No. 202311537342.2, filed with the China National Intellectual Property Administration on November 16, 2023 and entitled "RESONATOR, FILTER, AND ELECTRONIC DEVICE", which is incorporated herein by reference in its entirety.

## TECHNICAL FIELD

This application relates to the field of resonator technologies, and relates to a resonator, a filter having a resonator, and an electronic device including a filter or a resonator.

## BACKGROUND

With development of communication technologies, a quantity of resonators needed for an electronic device significantly increases. For example, bulk acoustic resonators such as a horizontally-excited bulk acoustic resonator (Horizontally-excited Bulk Acoustic Resonator, XBAR), a vertically-excited bulk acoustic resonator (Vertically-excited Bulk Acoustic Resonator, YBAR), and a film bulk acoustic resonator (Film Bulk Acoustic Resonator, FBAR) have attracted wide attention.

The YBAR has greater coupling and a more effective resonance mode, and may be used in a larger passband bandwidth.

However, in a YBAR device, because a piezoelectric layer is attached to a substrate, acoustic resonance vibration of a part that is of the piezoelectric layer and that is close to the substrate is restricted, and consequently, an increase in an electromechanical coupling factor of the resonator is suppressed.

## SUMMARY

This application provides a resonator, a filter having a resonator, and an electronic device including a filter, to provide a resonator that can increase an electromechanical coupling factor.

To achieve the foregoing objectives, the following technical solutions are used in embodiments of this application.

According to an aspect, this application provides a resonator. In an embodiment, the resonator may be an acoustic resonator, for example, a YBAR.

The resonator includes a substrate, a first electrode, a piezoelectric transducer layer, and a plurality of second electrodes. The first electrode, the piezoelectric transducer layer, and the plurality of second electrodes are disposed on the substrate, the piezoelectric transducer layer has a first side and a second side, the plurality of second electrodes are located on the first side and arranged side by side in a first direction, the first electrode is located on the second side, the first side faces away from the substrate, and the second side faces toward the substrate. The piezoelectric transducer layer includes a first piezoelectric layer and a second piezoelectric layer that are stacked. The first piezoelectric layer has a first piezoelectric tensor component $e_{33}$, the second piezoelectric layer has a second piezoelectric tensor component $e_{33}$, and the first piezoelectric tensor component $e_{33}$ is opposite to the second piezoelectric tensor component $e_{33}$. In other words, the first piezoelectric tensor component $e_{33}$ and the second piezoelectric tensor component $e_{33}$ are opposite numbers.

In the resonator provided in this application, the piezoelectric transducer layer includes a plurality of layers, for example, includes the first piezoelectric layer and the second piezoelectric layer that are stacked. The first piezoelectric tensor component $e_{33}$ of the first piezoelectric layer is opposite to the second piezoelectric tensor component $e_{33}$ of the second piezoelectric layer. In this case, under an action of an electric field, a deformation direction of the first piezoelectric layer is opposite to a deformation direction of the second piezoelectric layer. For example, along a stacking direction of the first piezoelectric layer and the second piezoelectric layer, when the first piezoelectric layer is stretched and the second piezoelectric layer is compressed, a vibration direction of a part that is of the first piezoelectric layer and that is attached to the second piezoelectric layer faces the second piezoelectric layer, and a vibration direction of a part that is of the second piezoelectric layer and that is attached to the first piezoelectric layer also faces the second piezoelectric layer. The two vibrations are coupled and resonant at a position at which the first piezoelectric layer is attached to the second piezoelectric layer, so that mechanical vibration is also generated inside the entire piezoelectric transducer layer, to increase an electromechanical coupling factor of the entire resonator.

In a possible implementation, the first electrode includes a first surface and a second surface that face away from each other, the second surface is closer to the substrate than the first surface, and the second surface of the first electrode is fully disposed on the substrate.

The resonator provided in this example may be referred to as a solid-state substrate resonator, and according to the resonator of this structure, a heat dissipation capability and robustness of the device can be improved.

In a possible implementation, a spacing is provided between two adjacent second electrodes; and a groove is provided at a position that is on the piezoelectric transducer layer and that is opposite to the spacing, and the groove penetrates with the spacing.

The groove is formed on the piezoelectric transducer layer. This helps further increase the electromechanical coupling factor of the resonator and suppress or frequency-shift a parasitic spurious mode.

In a possible implementation, a thickness H of the piezoelectric transducer layer and a depth h of the groove satisfy: $30\%H \le h \le H$.

When the depth of the groove is small, vibration of parts that are of the piezoelectric transducer layer and that are located at the first electrode and the second electrode is restricted.

In a possible implementation, the first piezoelectric layer is disposed closer to the substrate than the second piezoelectric layer; and the second piezoelectric layer has a top surface away from the first piezoelectric layer, the first piezoelectric layer has a bottom surface away from the second piezoelectric layer, and the groove passes through the top surface and the bottom surface.

The groove passes through the piezoelectric transducer layer from the top surface to the bottom surface, so that the electromechanical coupling factor can be further increased.

In a possible implementation, from the top surface to the bottom surface, a radial size of the groove gradually increases.

For example, a tilt angle $\alpha$ of a side surface of the groove satisfies: $45° < \alpha < 90°$, or $60° < \alpha < 90°$.

In a possible implementation, a thickness S1 of the second electrode and the thickness H of the piezoelectric transducer layer satisfy $S1/_H \le 0.35$.

In a possible implementation, a thickness S2 of the first electrode and the thickness H of the piezoelectric transducer layer satisfy $S2/_H \le 0.35$.

In some examples, to reduce an acoustic loss at the electrode, the thickness of the first electrode or the thickness of the second electrode may be reduced. However, when the thickness of the electrode becomes thinner, a power tolerance capability of the electrode is reduced. In an example of this application, the thickness of the piezoelectric transducer layer may be increased, to reduce a thickness ratio of the electrode to the piezoelectric transducer layer. This imposes no challenge on an etching process, and does not reduce the power tolerance capability of the electrode.

In a possible implementation, the resonator further includes a first busbar and a second busbar; in every two adjacent second electrodes in the plurality of second electrodes, one is a first interdigital electrode, the other is a second interdigital electrode, and the first interdigital electrode and the second interdigital electrode are spaced apart in the first direction; a plurality of first interdigital electrodes in the plurality of second electrodes are connected through the first busbar, and a plurality of second interdigital electrodes in the plurality of second electrodes are connected through the second busbar; a pitch P and the thickness H of the piezoelectric transducer layer satisfy: $P/H \ge 1$; and a width of each first interdigital electrode is t1, a spacing between each pair of the first interdigital electrode and the second interdigital electrode that are adjacent is t2, the pitch $P = t1 + t2$, and the width is a size in a direction parallel to a surface of the substrate and perpendicular to an extension direction of the first interdigital electrode.

To increase a resonance frequency of the resonator, the pitch P may be reduced. However, a small pitch P imposes a challenge to an etching process, and leads to a parasitic spurious mode. In this embodiment of this application, the piezoelectric layer that includes a plurality of stacked layers is used, and a thickness ratio of the pitch to the piezoelectric layer is limited. This imposes no challenge on the etching process, and suppresses the parasitic spurious mode.

In a possible implementation, a thickness of the first piezoelectric layer is S1, a thickness of the second piezoelectric layer is S2, and S1 and S2 are equal or close to each other.

In a possible implementation, by applying a voltage to the plurality of second electrodes, the resonator is configured to excite the piezoelectric transducer layer to generate a first resonance mode, and a vibration direction of the first resonance mode is perpendicular to the surface of the substrate.

The first resonance mode is a primary resonance mode of the resonator.

In a possible implementation, the first piezoelectric layer includes a first piezoelectric material, and the second piezoelectric layer includes a second piezoelectric material. A Euler angle of a crystal of the first piezoelectric material is (0°, 0°, 0°), a Euler angle of a crystal of the second piezoelectric material is (0°, 180°, 0°), a c-axis of a piezoelectric material of the first piezoelectric layer is opposite to a c-axis of a piezoelectric material of the second piezoelectric layer, and one of the c-axes is oriented upward along the thickness of the piezoelectric layer, and the other of the c-axes is oriented downward along the thickness of the piezoelectric layer.

In a possible implementation, an electromechanical coupling factor $Kt^2$ of the resonator $\ge 23\%$.

In a possible implementation, a material of the piezoelectric transducer layer includes a combination of nitrogen, scandium, and aluminum, and a mass fraction of the scandium is greater than or equal to 10%, or may be less than or equal to 40%.

For example, the mass fraction of the scandium may be 25%, 30%, or 40%.

In a possible implementation, the material of the piezoelectric transducer layer includes a combination of zinc and oxygen, for example, zinc oxide. The material of the piezoelectric transducer layer may alternatively include quartz or a lead zirconium titanate (PZT) material.

In a possible implementation, a dielectric layer is stacked between the substrate and the first electrode, and a thickness g of the dielectric layer satisfies: $g=\lambda/4$, where $\lambda$ is a wavelength of an acoustic wave of the resonator at the resonance frequency in a material of the dielectric layer.

The dielectric layer is disposed between the substrate and the first electrode to prevent coupling between the piezoelectric layer and the substrate, so that the electromechanical coupling factor of the device can be increased. In addition, when the thickness g of the dielectric layer satisfies: $g=\lambda/4$, the electromechanical coupling factor can be further increased.

According to another aspect, this application further provides a filter. The filter may include a plurality of electrically connected resonators, and at least one of the plurality of resonators may be the foregoing resonator.

The filter provided in this application includes the resonator in the foregoing implementation structures, and the resonator includes at least two piezoelectric layers whose polarization directions are opposite, so that the resonator has a large electromechanical coupling factor. The resonator is used in the filter, so that out-of-band suppression performance of the filter can be improved.

According to still another aspect, this application further provides a duplexer. The duplexer includes a transmit channel filter and a receive channel filter. At least one of the transmit channel filter and the receive channel filter may perform filtering by using the foregoing filter.

According to yet another aspect, this application further provides a multiplexer. The multiplexer includes a plurality of transmit channel filters and a plurality of receive channel filters. At least one of the plurality of transmit channel filters or at least one of the plurality of receive channel filters may be the filter in embodiments of this application.

According to yet another aspect, this application further provides an electronic device. The electronic device includes an amplifier, and the filter, the duplexer, or the multiplexer in the foregoing possible implementations. The filter, the duplexer, or the multiplexer may be electrically connected to the amplifier.

The electronic device provided in embodiments of this application includes the foregoing filter, duplexer, or multiplexer. Therefore, the electronic device provided in embodiments of this application and the filter, the duplexer, or the multiplexer in the foregoing technical solutions can resolve a same technical problem, with same expected effect achieved.

According to yet another aspect, this application further provides a preparation method for a resonator. The production method includes:

preparing a first electrode on a substrate;
preparing a first piezoelectric layer on the first electrode, and preparing a second piezoelectric layer on the first piezoelectric layer, where the first piezoelectric layer has a first piezoelectric tensor component $e_{33}$, the second piezoelectric layer has a second piezoelectric tensor component $e_{33}$, and the first piezoelectric tensor component $e_{33}$ is opposite to the second piezoelectric tensor component $e_{33}$; and
preparing a plurality of second electrodes on the second piezoelectric layer, where the plurality of second electrodes are arranged side by side in a first direction.

In the resonator prepared according to the foregoing method, a piezoelectric transducer layer includes a plurality of stacked piezoelectric layers, and two adjacent piezoelectric layers have opposite piezoelectric tensor component polarities. In this way, when the resonator operates, resonance coupling is generated at an interface between the two adjacent piezoelectric layers, to increase an electromechanical coupling factor of the resonator.

In a possible implementation, the first piezoelectric layer and the second piezoelectric layer are prepared by using an epitaxial growth technology.

In a possible implementation, when the plurality of second electrodes are prepared on the second piezoelectric layer, the method includes: disposing the plurality of second electrodes that are arranged side by side on the second piezoelectric layer, where a spacing is provided between two adjacent second electrodes; and providing a groove at a position that is on the piezoelectric transducer layer that includes the first piezoelectric layer and the second piezoelectric layer and that is opposite to the spacing.

In a possible implementation, the groove passes through the first piezoelectric layer and the second piezoelectric layer.

## BRIEF DESCRIPTION OF DRAWINGS

FIG. 1 is a diagram of a part of a structure of an electronic device;

FIG. 2 is a diagram of a part of a structure of an electronic device;

FIG. 3 is a diagram of a part of a structure of a filter in an electronic device;

FIG. 4 is a diagram of a part of a structure of a resonator;

FIG. 5 is a diagram of a part of a structure of a resonator according to an embodiment of this application;

FIG. 6 is a diagram of a structure illustrating vibration of a resonator according to an embodiment of this application;

FIG. 7 is a diagram of a structure illustrating vibration of a resonator according to a related technology;

FIG. 8 is a diagram of a structure illustrating vibration of a resonator according to a related technology;

FIG. 9 is a diagram of a part of a structure of a resonator according to an embodiment of this application;

FIG. 10 is a diagram of a part of a structure of a resonator according to an embodiment of this application;

FIG. 11 is a diagram of a part of a structure of a resonator according to an embodiment of this application;

FIG. 12 is a diagram of a part of a structure of a resonator according to an embodiment of this application;

FIG. 13 is a diagram of a structure illustrating vibration of a resonator according to a related technology;

FIG. 14 is a diagram of a structure illustrating vibration of a resonator according to an embodiment of this application;

FIG. 15 is a diagram of a part of a structure of a resonator according to an embodiment of this application;

FIG. 16 is a diagram of a part of a structure of a resonator according to an embodiment of this application;

FIG. 17A is a diagram of a structure illustrating vibration of a resonator according to an embodiment of this application;

FIG. 17B is a diagram of a structure illustrating vibration of a resonator according to a related technology;

FIG. 18A is an admittance curve diagram of the structure shown in FIG. 17A;

FIG. 18B is an admittance curve diagram of the structure shown in FIG. 17B;

FIG. 19 is a process flowchart of a preparation method for a resonator according to an embodiment of this application;

FIG. 20 is a diagram of a structure of a filter according to an embodiment of this application; and

FIG. 21 is a diagram of admittance curves of resonators in FIG. 20 and a filter passband.

Reference numerals:

100: electronic device;
200: filter;
300: resonator;
400, 410, 420, 430 and 440: resonators;
500: antenna;
600: receiver;
700: transmitter;
800: baseband chip;
900: switch;
60a, 60c, and 70a: filters; 60b: low noise amplifier; 60d: frequency mixer; 60e: buffer; 60f and 70d: voltage-controlled oscillators; 70b: amplifier; 70c: driver;

10: substrate; 101: cavity;

20: first electrode;

30: piezoelectric transducer layer; 301: first piezoelectric layer; 302: second piezoelectric layer;

40: second electrode; 401: first interdigital electrode; 402: second interdigital electrode;

50: dielectric layer;

601: first busbar; 602: second busbar;

70: groove.

## DESCRIPTION OF EMBODIMENTS

Before a structure that can be implemented in embodiments of this application is described, technical terms in embodiments of this application are first described.

Piezoelectric effect, including direct piezoelectric effect and converse piezoelectric effect: The direct piezoelectric effect means that electric polarization of a piezoelectric material changes when the piezoelectric material is subject to a mechanical force. The converse piezoelectric effect means that a piezoelectric material is deformed after an external electric field is applied to the material. The piezoelectric effect is mainly caused by anisotropy and polarization of a crystal structure of the piezoelectric material.

Primary resonance mode and parasitic spurious mode: A position of a parasitic resonance frequency generated by a resonator may be close to a position of a primary resonance frequency, and parasitic resonance may affect the primary resonance mode, and further affect in-band insertion loss performance and out-of-band suppression performance of a filter. The parasitic resonance of the resonator is usually referred to as a spurious mode or the parasitic spurious mode. When the spurious mode falls near the primary resonance mode, for example, falls near a resonance point and an anti-resonance point of the primary resonance mode, the in-band insertion loss performance and the out-of-band suppression performance of the filter are affected.

Electromechanical coupling factor (Piezoelectric coupling factor) $Kt^2$: is a key parameter of the resonator. The electromechanical coupling factor $Kt^2$ may reflect conversion efficiency between mechanical energy and electric energy. The electromechanical coupling factor $Kt^2$ of the resonator determines a relative frequency width of an anti-resonance frequency and a resonance frequency of the resonator. For example, when the resonator is used in a filter design, the relative frequency width directly determines bandwidth of the filter. It can be considered that a larger electromechanical coupling factor $Kt^2$ indicates a larger bandwidth and better performance of a filter constructed in a trapezoidal structure.

Piezoelectric tensor component: A single-crystal piezoelectric material has a fourth-order elasticity tensor c, a third-order piezoelectric tensor e, and a second-order dielectric tensor $\varepsilon$. Based on a right-handed rectangular coordinate system, the single-crystal piezoelectric material has an elasticity tensor component $c_{ijkl}$, a piezoelectric tensor component $e_{ijk}$, and a dielectric tensor component $\varepsilon_{ij}$, where i, j, k, l={1, 2, 3}. Due to symmetry of a single-crystal structure, for example, $c_{1323}=c_{3132}$, a component order may be simplified by defining {23, 32}→4, {13, 31}→5, and {12, 21}→6, for example, $c_{1323}=c_{3132}\rightarrow c_{54}$. In this case, an elasticity tensor component $c_{xy}$(6×6), a piezoelectric tensor component $e_{ix}$(3×6), and a dielectric tensor component $\varepsilon_{ij}$(3×3) are obtained, where i, j={1, 2, 3}, and x, y={1, 2, 3, 4, 5, 6}. An electromechanical coupling factor component $kxy^2$ is calculated based on the elasticity tensor component, the piezoelectric tensor component, and the dielectric tensor component of the material. A formula is as follows:

$$k_{xy}^{\ 2} = \frac{e_{xy}^{\ 2}}{\varepsilon_{xx}^{\ S} c_{yy}^{\ E}}$$

x={1, 2, 3}, y={1, 2, 3, 4, 5, 6}, $\varepsilon_{xx}^{\ S}$ is a dielectric tensor component under fixed strain, and $c_{yy}^{\ E}$ is an elasticity tensor component under fixed electric field strength.

The following describes methods and formulas for calculating the elasticity tensor component, the piezoelectric tensor component, and the dielectric tensor component at different Euler angles of crystals.

For a crystal orientation of a piezoelectric material with a Euler angle of (0, 0, 0), for example, LN:

$c^E_{11}$=2.03, $c^E_{12}$=0.53, $c^E_{13}$=0.75, $c^E_{14}$=0.09, $c^E_{44}$=0.60, $c^E_{33}$=2.43, $c^E_{22}$=$c^E_{11}$, $c^E_{23}$=$c^E_{13}$, $c^E_{24}$=-$c^E_{14}$, $c^E_{55}$=$c^E_{44}$, $c^E_{56}$=$c^E_{14}$, $c^E_{66}$=($c^E_{11}$-$c^E_{12}$)/2, measured in a unit of ×$10^{11}$ N/m²; and

$e_{15}$=3.70, $e_{16}$=-2.53, $e_{31}$=0.19, $e_{33}$=1.31, $e_{21}$=$e_{16}$, $e_{20}$=-$e_{16}$, $e_{24}$=$e_{15}$, $e_{32}$=$e_{31}$, measured in a unit of C/m²; and

$\varepsilon^S_{11}$=43.6×$\varepsilon_0$, $\varepsilon^S_{33}$=29.2×$\varepsilon_0$, and $\varepsilon^S_{22}$=$\varepsilon^S_{11}$, where $\varepsilon_0$ is a vacuum dielectric constant: 8.85× $10^{-12}$ F/m. Other components may be obtained based on tensor symmetry, and a component without a value is zero. The components are expressed in simplified forms. The fourth-order elasticity tensor component $c^E_{ijkl}$ and the third-order piezoelectric tensor component $e_{ijk}$ may be correspondingly obtained through expansion.

In this case, for a crystal orientation of a piezoelectric material with a Euler angle of $(\alpha, \beta, \gamma)$, an elasticity tensor component $c^E_{pqrs}{}'$, a piezoelectric tensor component $e_{pqr}{}'$, and a dielectric tensor component $\varepsilon^S_{pq}{}'$ that correspond to the crystal orientation may be calculated by using the following formulas:

$$c^E_{pqrs}{}' = c^E_{ijkl}\, A_{ip}\, A_{jq}\, A_{kr}\, A_{ls};$$

$$e_{pqr}{}' = e_{ijk}\, A_{ip}\, A_{jq}\, A_{kr};$$

and

$$\varepsilon^S_{pq}{}' = \varepsilon^S_{ij}\, A_{ip}\, A_{jq}.$$

The Einstein summation convention is used in the formulas, where a $3\times3$ matrix $A=(\cos\alpha\cos\gamma-\sin\alpha\cos\beta\sin\gamma, -\cos\alpha\sin\gamma-\sin\alpha\cos\beta\cos\gamma, \sin\alpha\sin\beta; \sin\alpha\cos\gamma+\cos\alpha\cos\beta\sin\gamma, -\sin\alpha\sin\gamma+\cos\alpha\cos\beta\cos\gamma, -\cos\alpha\sin\beta; \sin\beta\sin\gamma, \sin\beta\cos\gamma, \cos\beta)$.

Euler angle (Euler angle) of a piezoelectric material: The Euler angle (Euler angle) represents a relative rotation angle relationship between an X direction or a Y direction of an original piezoelectric crystal structure and a direction, on a wafer plane, that is perpendicular or parallel to an electrode extension direction of a resonator.

Admittance (admittance): In power electronics, admittance is defined as a reciprocal of impedance (impedance), is represented by a symbol Y, and is measured in a unit of siemens, S (S) for short. Like the impedance, the admittance is also a complex number, including a real number part (conductance G) and an imaginary number part (susceptance B): $Y=G+jB$.

Admittance curve abs and admittance curve Re: Admittance curve $abs(Y)=|Y|$, which is a modulus (also referred to as an amplitude) of Y and represents an overall response of a resonator. $Re(Y)$ is a real part of Y, namely, conductance G, and represents a loss of the resonator.

An embodiment of this application provides an electronic device. The electronic device includes but is not limited to a radio frequency front-end, a filter and amplification module, and other products, and may further include a mobile phone (mobile phone), a tablet computer (pad), an intelligent wearable product (for example, a smartwatch or a smart band), a virtual reality (virtual reality, VR) device, an augmented reality (augmented reality, AR) device, an uncrewed aerial vehicle, or other terminal devices, or may be a base station, a television, a router, a vehicle, or another device. A specific form of the electronic device is not particularly limited in embodiments of this application.

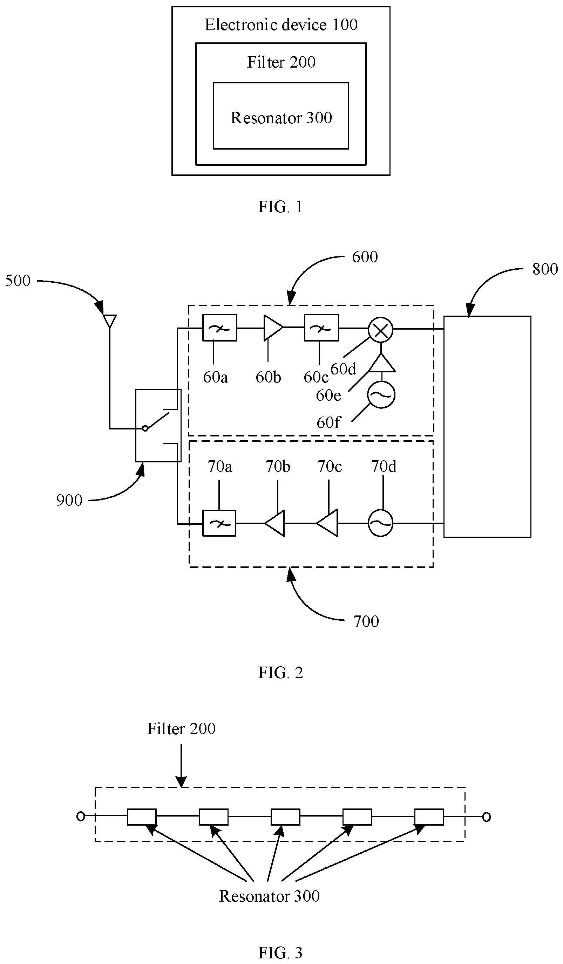

In the foregoing electronic device, as shown in FIG. 1, an electronic device 100 may include a filter 200. The filter 200 may effectively filter out a specific frequency or a frequency other than the frequency from a signal, to obtain a signal with a specific frequency or a signal obtained by eliminating a specific frequency, to improve operation performance of the electronic device 100.

FIG. 2 is a diagram of a part of a circuit of some electronic devices 100. As shown in FIG. 2, the electronic device 100 includes a receiver (Receiver) 600, a transmitter (Transmitter) 700, an antenna (Antenna) 500, and a baseband chip 800. The antenna 500 is electrically connected to the receiver 600 and the transmitter 700 via a switch 900, and the receiver 600 and the transmitter 700 are separately electrically connected to the baseband chip 800.

The receiver (Receiver) 600 shown in FIG. 2 includes a filter (Filter) 60a and a filter (Filter) 60c. A low noise amplifier 60b is electrically connected between the filter 60a and the filter 60c. The filter 60c is electrically connected to a buffer (Buffer) 60e through a frequency mixer (Mixer) 60d. The buffer 60e is electrically connected to a voltage-controlled oscillator 60f. FIG. 2 shows merely an example receiver, and an electronic component may be added or omitted based on this circuit structure.

The transmitter (Transmitter) 700 shown in FIG. 2 includes a power amplifier (power amplifier, PA) 70b. The power amplifier 70b is electrically connected to a filter 70a and a driver (Driver) 70c. The driver (Driver) 70c is electrically connected to a voltage-controlled oscillator 70d. Similarly, FIG. 2 shows merely an example transmitter, and an electronic component may be added or omitted based on this circuit structure.

For example, in the transmitter 700 shown in FIG. 2, the filter may effectively filter out a specific frequency amplified by the power amplifier or a frequency other than the frequency, or the filter may filter out noise of the low noise amplifier.

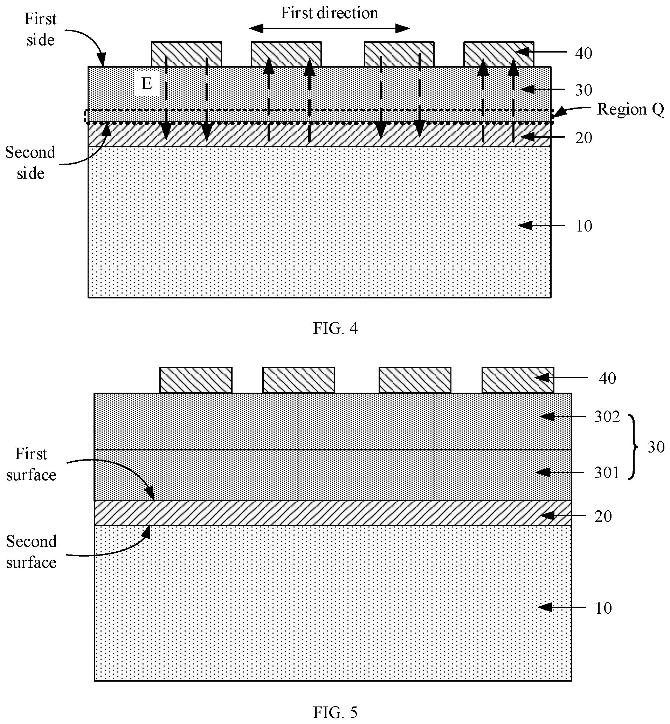

Further, as shown in FIG. 3, the filter 200 may include a plurality of resonators 300 that are connected in series, or include a plurality of resonators 300 that are connected in parallel, or include resonators 300 that are connected in series and parallel. At least one of the plurality of resonators included in the filter 200 may be a resonator shown in FIG. 4.

FIG. 4 is a diagram of a part of a process structure of a resonator. The resonator includes a substrate 10, a first electrode 20, a piezoelectric transducer layer 30, and a plurality of second electrodes 40. The first electrode 20, the piezoelectric transducer layer 30, and the plurality of second electrodes 40 are disposed on the substrate 10. The plurality of second electrodes 40 are arranged side by side in a first direction, the piezoelectric transducer layer 30 has a first side and a second side, the plurality of second electrodes 40 are located on the first side, the first electrode 20 is located on the second side, the first side faces away from the substrate 10, and the second side faces toward the substrate 10. For example, as shown in FIG. 4, the piezoelectric transducer layer 30 is stacked between the first electrode 20 and the plurality of second electrodes 40.

In the example resonator shown in FIG. 4, for the plurality of second electrodes 40 arranged in the first direction, the first direction may be understood as a direction perpendicular to or approximately perpendicular to an extension direction of the second electrode 40. In an embodiment, the first direction is perpendicular to a stacking direction of the piezoelectric transducer layer 30, the first electrode 20, and the second electrode 40.

The example structure in FIG. 4 may be used in a bulk acoustic resonator. A main operation principle of the bulk acoustic resonator is as follows: An input signal of a radio wave is converted into mechanical energy by using input and output transducers (Transducer) based on a piezoelectric effect characteristic of a piezoelectric material. Then the mechanical energy is converted into an electrical signal through processing, to filter out an unnecessary signal and noise, and improve signal reception quality.

During operation of the resonator shown in FIG. 4, the first electrode 20 may have no electrical signal connection, and an alternating voltage at a specific frequency is applied to the second electrode 40, so that an electric field E is generated between the first electrode 20 and the second electrode 40 along a thickness direction of the piezoelectric transducer layer 30. The piezoelectric transducer layer 30 uses the electric field to form piezoelectric effect. In the example in FIG. 4, the piezoelectric transducer layer 30 is excited by the vertical electric field E to generate resonance, to cause conversion between electric energy and mechanical energy.

In the resonator shown in FIG. 4, resonance is excited along the thickness direction of the piezoelectric transducer layer 30. In an embodiment, the resonator may be referred to as a vertically-excited bulk acoustic resonator (Vertically-excited Bulk Acoustic Resonator, YBAR). The thickness direction of the piezoelectric transducer layer 30 herein may be understood as a direction that is of the piezoelectric transducer layer 30 and that is parallel to a stacking direction of a plurality of film layers (including the substrate, the first electrode, and the piezoelectric layer).

As shown in FIG. 4, because a part (a region Q framed by a dashed line shown in FIG. 4) that is of the piezoelectric transducer layer 30 and that is close to the first electrode 20 is attached to the first electrode 20, acoustic resonance vibration of the region (the region Q framed by the dashed line shown in FIG. 4) is restricted, and consequently, a vibration amount of the piezoelectric transducer layer 30 is limited. As a result, an electromechanical coupling factor $Kt^2$ of the resonator is small, and the resonator cannot be applied to a larger passband bandwidth, for example, cannot satisfy a passband bandwidth of a sub-6 GHz frequency band to a sub-15 GHz frequency band.

To increase the electromechanical coupling factor $Kt^2$ of the resonator, this application provides some new resonator process structures as examples. Details are as follows.

FIG. 5 is a diagram of a process structure of a resonator according to an embodiment of this application. Similar to the resonator shown in FIG. 4, the resonator includes the substrate 10, and the first electrode 20, the piezoelectric transducer layer 30, and the plurality of second electrodes 40 stacked on the substrate 10. In addition, similarities also lie in that the second electrode 20 has a first surface and a second surface that face away from each other, the second surface is closer to the piezoelectric transducer layer 30 than the first surface, and the second surface of the first electrode 20 is fully disposed on the substrate 10. The resonator can be referred to as a solid-state substrate resonator.

A difference between the example shown in FIG. 5 and that shown in FIG. 4 lies in that, in FIG. 5, the piezoelectric transducer layer 30 includes a plurality of stacked layers. For example, FIG. 5 shows an example in which the piezoelectric transducer layer 30 includes a first piezoelectric layer 301 and a second piezoelectric layer 302 that are stacked. In some other examples, more piezoelectric layers may be included, for example, three, four, or more layers.

In a plurality of piezoelectric layers, some piezoelectric tensor components of two adjacent piezoelectric layers are opposite. For example, as shown in FIG. 5, the first piezoelectric layer 301 has a first piezoelectric tensor component, the second piezoelectric layer 302 has a second piezoelectric tensor component, and the first piezoelectric tensor component is opposite to the second piezoelectric tensor component. In other words, it may be understood that in this example of this application, adjacent piezoelectric layers have opposite piezoelectric tensor component polarities.

In some examples, the substrate 10 may be a high-sound-speed substrate, for example, may be made of any one or a combination of a plurality of silicon carbide (SiC), diamond (diamond), or boron nitride (BN).

The first electrode 20 may be made of any possible conductive metal (including but not limited to Al, Cu, W, Mo, Ru, Pt, and the like), or may be made of conductive metal (including but not limited to W, Ru, Mo, Pt, and the like) with high acoustic impedance. The metal with high acoustic impedance helps increase the electromechanical coupling factor and a quality factor Q, and further improve use performance of the resonator.

The second electrode 40 may be made of any possible conductive metal (including but not limited to Al, Cu, W, Mo, Ru, Pt, and the like).

The first electrode 20 and the second electrode 40 may be made of same conductive metal or different conductive metal.

In this example of this application, the first piezoelectric layer 301 has the first piezoelectric tensor component $e_{33}$, and the second piezoelectric layer 302 has the second piezoelectric tensor component $e_{33}$. The first piezoelectric tensor component $e_{33}$ and the second piezoelectric tensor component $e_{33}$ are opposite (that is, are opposite numbers), so that the two piezoelectric layers have opposite piezoelectric tensor component polarities.

In some examples, both the first piezoelectric layer 301 and the second piezoelectric layer 302 may include a wurtzite structure, for example, may include a combination of nitrogen and aluminum, or may include a combination of nitrogen, scandium, and aluminum, for example, may include an AlScN material. In AlScN, a mass fraction of Sc may be greater than or equal to 0 and less than or equal to 40%. In some examples, the mass fraction of Sc may be greater than or equal to 10%. For example, the mass fraction of Sc may be 20%, 30%, 35%, or 40%.

In some other examples, both the first piezoelectric layer 301 and the second piezoelectric layer 302 may include a combination of oxygen and zinc, for example, may include zinc oxide. The first piezoelectric layer 301 and the second piezoelectric layer 302 may alternatively include quartz or a lead zirconium titanate (PZT) material.

Both the piezoelectric material that includes a combination of nitrogen, scandium, and aluminum, and the zinc oxide in the foregoing example include the piezoelectric tensor component $e_{33}$. In this application, the piezoelectric tensor components $e_{33}$ in two adjacent piezoelectric layers may be opposite numbers.

In this example of this application, under an action of the piezoelectric tensor component $e_{33}$ of the piezoelectric layer, the resonator vibrates along a stacking direction of the first piezoelectric layer 301 and the second piezoelectric layer 302.

In some examples, both the first piezoelectric layer 301 and the second piezoelectric layer 302 include AlScN. When a Euler angle of a piezoelectric material of the first piezoelectric layer 301 is (0°, 90°, 0°), the piezoelectric tensor component $e_{33}$ of the first piezoelectric layer 301 = +2.42. When a Euler angle of a crystal of a piezoelectric material of the second piezoelectric layer 302 is (0°, 270°, 0°), the piezoelectric tensor component $e_{33}$ of the second piezoelectric layer 302 = -2.42.

A c-axis of the piezoelectric material of the first piezoelectric layer is opposite to a c-axis of the piezoelectric material of the second piezoelectric layer, and one of the c-axes is oriented upward along a thickness of the piezoelectric layer, and the other of the c-axes is oriented downward along the thickness of the piezoelectric layer.

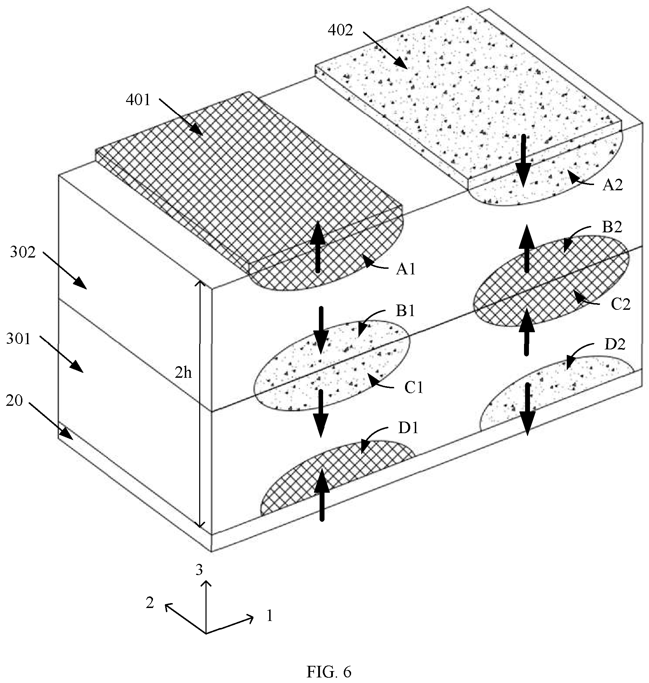

FIG. 6 shows an example of a principle of how the structure shown in FIG. 5 in this application increases the electromechanical coupling factor $Kt^2$.

In FIG. 6, both the first piezoelectric layer 301 and the second piezoelectric layer 302 may include AlScN, the piezoelectric tensor component $e_{33}$ of the first piezoelectric layer 301 is opposite to the piezoelectric tensor component $e_{33}$ of the second piezoelectric layer 302, and a vibration direction of the first piezoelectric layer 301 and a vibration direction of the second piezoelectric layer 302 are both along a direction 3. The first piezoelectric layer 301 is disposed closer to the first electrode 20 than the second piezoelectric layer 302. FIG. 6 shows an example of a second electrode 401 and a second electrode 402 in the second electrode. A filling pattern in FIG. 6 shows an approximate vibration region of the resonator.

For example, when a positive voltage is applied to the second electrode 401, because the first piezoelectric layer 301 and the second piezoelectric layer 302 have opposite piezoelectric tensor component polarization, the first piezoelectric layer 301 may be compressed along the direction 3, and the second piezoelectric layer 302 may be stretched along the direction 3.

When the second piezoelectric layer 302 is stretched along the direction 3, a part (for example, a part A1 in FIG. 6) that is of the second piezoelectric layer 302 and that is close to the second electrode 401 vibrates upward, and a part (for example, a part B1 in FIG. 6) that is of the second piezoelectric layer 302 and that is close to the first piezoelectric layer 301 vibrates downward. When the first piezoelectric layer 301 is compressed along the direction 3, a part (for example, a part C1 in FIG. 6) that is of the first piezoelectric layer 301 and that is close to the second piezoelectric layer 302 vibrates downward, and a part (for example, a part D1 in FIG. 6) that is of the first piezoelectric layer 301 and that is close to the first electrode 20 vibrates upward.

As shown in FIG. 6, between the second electrode 401 and the first electrode 20, at a position at which the first piezoelectric layer 301 and the second piezoelectric layer 302 are attached, two downward vibrations are coupled, so that mechanical vibration is generated inside the entire piezoelectric layer.

For another example, when a negative voltage is applied to the second electrode 401, because the first piezoelectric layer 301 and the second piezoelectric layer 302 have opposite piezoelectric tensor component polarization, the first piezoelectric layer 301 may be stretched along the direction 3, and the second piezoelectric layer 302 may be compressed along the direction 3.

When the second piezoelectric layer 302 is compressed along the direction 3, a part (for example, a part A2 in FIG. 6) that is of the second piezoelectric layer 302 and that is close to the second electrode 401 vibrates downward, and a part (for example, a part B2 in FIG. 6) that is of the second piezoelectric layer 302 and that is close to the first piezoelectric layer 301 vibrates upward. When the first piezoelectric layer 301 is stretched along the direction 3, a part (for example, a part C2 in FIG. 6) that is of the first piezoelectric layer 301 and that is close to the second piezoelectric layer 302 vibrates upward, and a part (for example, a part D2 in FIG. 6) that is of the first piezoelectric layer 301 and that is close to the first electrode 20 vibrates downward.

As shown in FIG. 6, between the second electrode 402 and the first electrode 20, at a position at which the first piezoelectric layer 301 and the second piezoelectric layer 302 are attached, two upward vibrations are coupled, so that mechanical vibration is generated inside the entire piezoelectric layer.

In this way, in the structure of the resonator shown in FIG. 6 in an example of this application, when piezoelectric tensor component polarities of adjacent piezoelectric layers are opposite, coupling resonance is generated at an interface of the plurality of piezoelectric layers, so that the electromechanical coupling factor $Kt^2$ is increased.

This example of this application is different from a resonator (for example, a film bulk acoustic resonator (FBAR)) in which the second electrode 401 and the second electrode 402 are connected as a whole in that, a spacing is provided between the second electrode 401 and the second electrode 402, so that the second electrode 401 in FIG. 6 of this application is not constrained by the second electrode 402, and has a larger degree of freedom. In this way, as shown in FIG. 6, the second electrode 402 can also vibrate along the direction 3, to increase a vibration amount of the entire resonator.

Similarly, this example of this application is different from a resonator (for example, a film bulk acoustic resonator (FBAR)) in which the second electrode 401 and the second electrode 402 are connected as a whole in that, a spacing is provided between the second electrode 401 and the second electrode 402, so that the second electrode 402 in FIG. 6 of this application is not constrained by the second electrode 401 or another second electrode, and the second electrode 402 has a larger degree of freedom. In this way, as shown in FIG. 6, the second electrode 402 can also vibrate along the direction 3, to increase a vibration amount of the entire resonator. In this way, the electromechanical coupling factor $Kt^2$ of the resonator can be further increased.

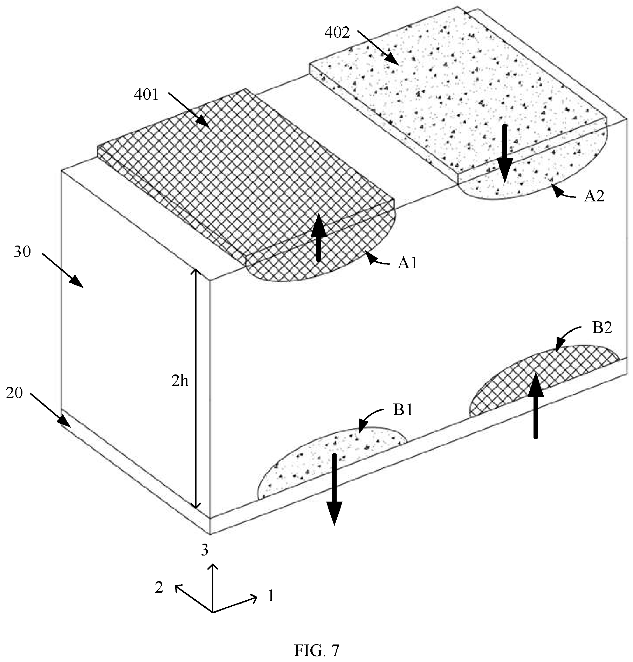

FIG. 7 is an example of a diagram of vibration of a resonator that includes one piezoelectric layer. A part (for example, a part A1 in FIG. 7) that is of the piezoelectric transducer layer 30 and that is attached to the second electrode 401 vibrates upward, and a part (for example, a part B1 in FIG. 7) that is of the piezoelectric transducer layer 30 and that is attached to the first electrode 20 vibrates downward.

FIG. 7 is different from FIG. 6 in that, basically no vibration is generated inside the piezoelectric transducer layer 30. However, in FIG. 6 of the example of this application, vibration is generated at an upper surface and a lower surface of the piezoelectric layer and at an interface of adjacent piezoelectric layers. In some scenarios, even if vibration of a part that is of the piezoelectric layer and that is attached to the first electrode 20 is restricted, according to the resonator in this example of this application, the electromechanical coupling factor $Kt^2$ can still be increased.

FIG. 6 is different from FIG. 7 in that, a sum of a thickness of the first piezoelectric layer 301 and a thickness of the second piezoelectric layer 302 in FIG. 6 is 2h, which is basically equal to or close to a thickness of the piezoelectric transducer layer 30 in FIG. 7. A resonance frequency in FIG. 6 is basically the same as or close to a resonance frequency in FIG. 7.

According to the resonator in FIG. 6 in the example of this application, the electromechanical coupling factor $Kt^2$ can be increased when it is ensured that the resonance frequency meets a requirement.

The direction 3 in this embodiment of this application may be understood as a direction perpendicular to a surface of the substrate 10 or parallel to the stacking direction of the first piezoelectric layer 301 and the second piezoelectric layer 302. The direction 1 may be understood as a direction parallel to the surface of the substrate 10 and perpendicular to the extension direction of the second electrode 40. A direction 2 may be understood as a direction parallel to the extension direction of the second electrode 40.

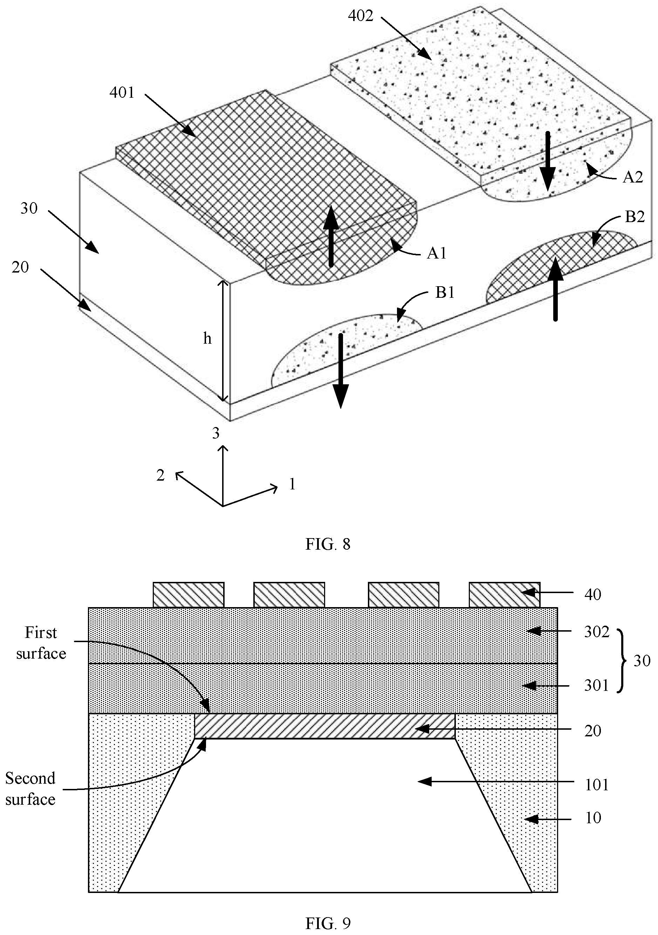

In some examples, to increase the resonance frequency, a resonator shown in FIG. 8 may alternatively be used. FIG. 8 is different from FIG. 7 in that, in FIG. 8, the thickness of the piezoelectric transducer layer 30 of a one-layer structure is h, and the thickness of the piezoelectric transducer layer 30 of a one-layer structure in FIG. 7 is 2h. For example, in FIG. 7, the resonance frequency may be f, and in FIG. 8, the resonance frequency may be 2f. In other words, the thickness of the piezoelectric transducer layer 30 may be reduced to increase the resonance frequency of the resonator. However, in a fabrication process, when the thickness of the piezoelectric transducer layer 30 is reduced to increase the resonance frequency, a large challenge may be present to photolithography. As a result, the increase of the resonance frequency is limited to some extent, and high-frequency application of the resonators shown in FIG. 7 and FIG. 8 is limited.

However, when the resonator shown in FIG. 6 is used, a limitation of the photolithography is mitigated through stacking of a plurality of piezoelectric layers, so that the resonator can be applicable to a high frequency range when stability and robustness of the resonator are improved.

FIG. 9 is a diagram of a process structure of another resonator according to an example of this application. In the resonator, the substrate 10 is provided with a cavity 101, and such a resonator may be referred to as a suspended piezoelectric thin-film resonator with an air cavity.

In FIG. 9, the second electrode 20 has the first surface and the second surface that face away from each other. The first surface is closer to the piezoelectric transducer layer 30 than the second surface. The cavity 101 is provided in the substrate 10. At least a part of the second surface of the first electrode 20 is configured to enclose the cavity 101, and at least a part of the first electrode 20 is disposed between the cavity 101 and the piezoelectric transducer layer 30.

**EP 4 749 919 A1**

In this example, the piezoelectric transducer layer 30 may also include a plurality of stacked layers, for example, include the first piezoelectric layer 301 and the second piezoelectric layer 302 that are stacked. In the plurality of piezoelectric layers, adjacent piezoelectric layers have opposite piezoelectric tensor component polarities. For example, the piezoelectric tensor component $e_{33}$ of the first piezoelectric layer 301 is opposite to the piezoelectric tensor component $e_{33}$ of the second piezoelectric layer 302.

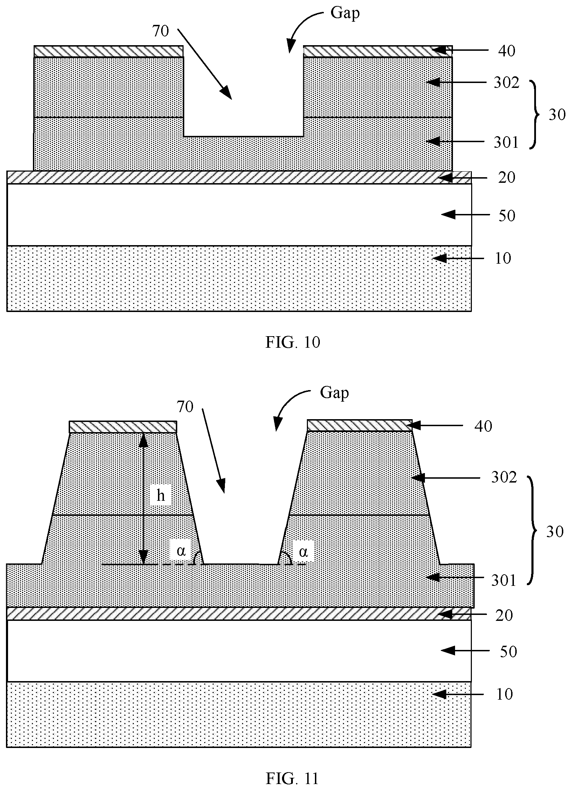

FIG. 10, FIG. 11, and FIG. 12 are diagrams of process structures of another three resonators according to an embodiment of this application. In this example, a dielectric layer 50 is further included, and the dielectric layer 50 is stacked between the substrate 10 and the first electrode 20. For example, the dielectric layer 50 may be silicon oxide ($SiO_2$).

In some examples, a thickness g of the dielectric layer 50 satisfies: $g=\lambda/4$, where $\lambda$ is a wavelength of an acoustic wave of the resonator at the resonance frequency in a material of the dielectric layer 50.

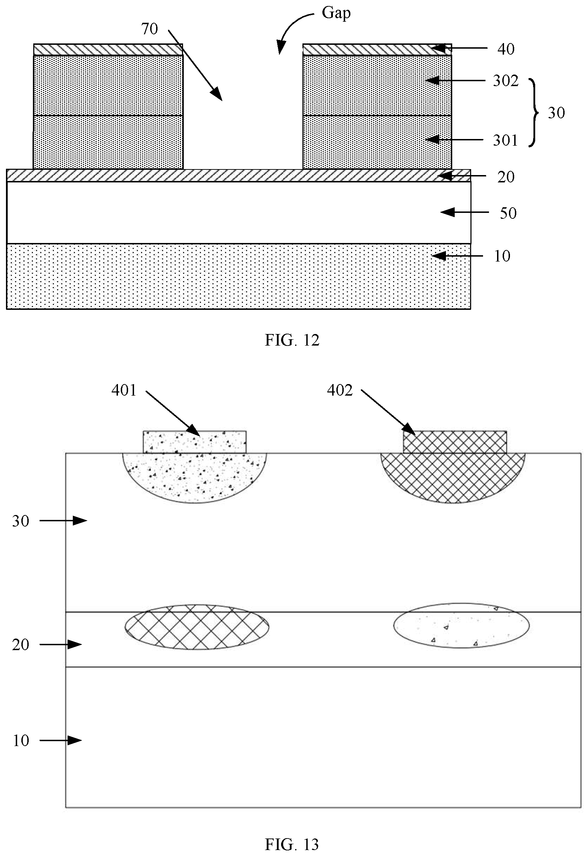

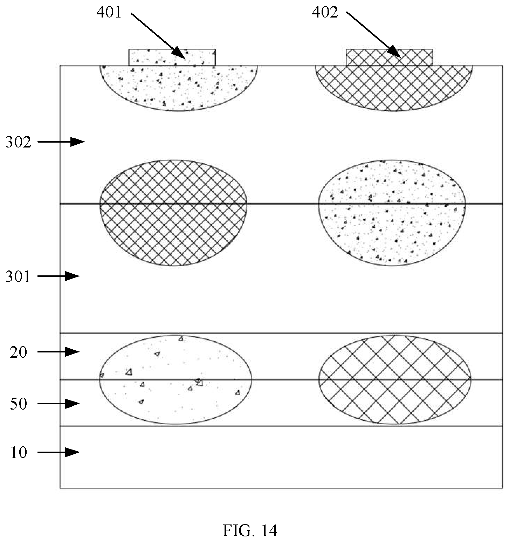

As shown in FIG. 13 and FIG. 14, in FIG. 13, the piezoelectric transducer layer 30 includes one piezoelectric layer. In FIG. 14, the piezoelectric transducer layer 30 includes the first piezoelectric layer 301 and the second piezoelectric layer 302 that are stacked, and further includes the dielectric layer 50 that is stacked between the substrate 10 and the first electrode 20.

In FIG. 13, the first electrode 20 of a metal layer is directly stacked on the substrate 10, and consequently, vibration amplitudes of the piezoelectric transducer layer 30 and the first electrode 20 are limited. As shown in FIG. 13, a vibration region and a vibration amplitude are very small. However, FIG. 14 is different from FIG. 13 in that, because the dielectric layer with small hardness is stacked between the substrate 10 and the first electrode 20, mechanical vibration is also generated in the first electrode 20 and the dielectric layer 50, so that a vibration amount of the entire resonator and the electromechanical coupling factor $Kt^2$ are increased.

Refer back to FIG. 10 to FIG. 12. The resonator is further provided with a groove 70, a spacing is provided between two adjacent second electrodes 40, the groove 70 is provided in the piezoelectric transducer layer 30, and the groove 70 is opposite to the spacing. In other words, it may be understood that the groove 70 penetrates with the spacing.

In some examples, as shown in FIG. 10 and FIG. 11, the first piezoelectric layer 301 is closer to the substrate 10 than the second piezoelectric layer 302, and the groove 70 may pass through the second piezoelectric layer 302 and a part of the first piezoelectric layer 301. In some other examples, as shown in FIG. 12, the groove 70 may pass through the second piezoelectric layer 302 and the first piezoelectric layer 301 until reaching the surface of the first electrode 20.

In other words, it may be understood that, in this example of this application, the groove 70 may pass through a part of the piezoelectric transducer layer 30, or may pass through all of the piezoelectric transducer layer 30 until reaching the surface of the first electrode 20.

The groove is provided in the plurality of piezoelectric layers, so that a limitation on the piezoelectric layer can be reduced, to further increase the electromechanical coupling factor $Kt^2$ of the resonator. In addition, the groove 70 further helps suppress or frequency-shift a parasitic mode.

In some implementation structures, a deeper groove 70 indicates a higher electromechanical coupling factor $Kt^2$ of the resonator. In this embodiment of this application, as shown in FIG. 11, a depth h of the groove 70 may be made to satisfy: $30\%H\leq h\leq H$, where H is the thickness of the piezoelectric transducer layer 30. For example, h=50% H, h=60% H, h=70% H, h=80% H, h=90% H, or h=H.

In addition, in some examples that can be implemented, a radial size of the groove 70 gradually decreases in a direction from a top surface to a bottom surface. For example, as shown in FIG. 11, a tilt angle $\alpha$ of the groove 70 may satisfy: $45°\leq\alpha\leq90°$. For example, in FIG. 11, the tilt angle $\alpha$ is approximately 60°, and in FIG. 10 and FIG. 12, the tilt angle $\alpha$ is approximately 90°.

The tilt angle $\alpha$ of the groove 70 may be understood as an included angle between a side surface of the groove 70 and a reference plane, and the reference plane is a plane parallel to the surface of the substrate 10.

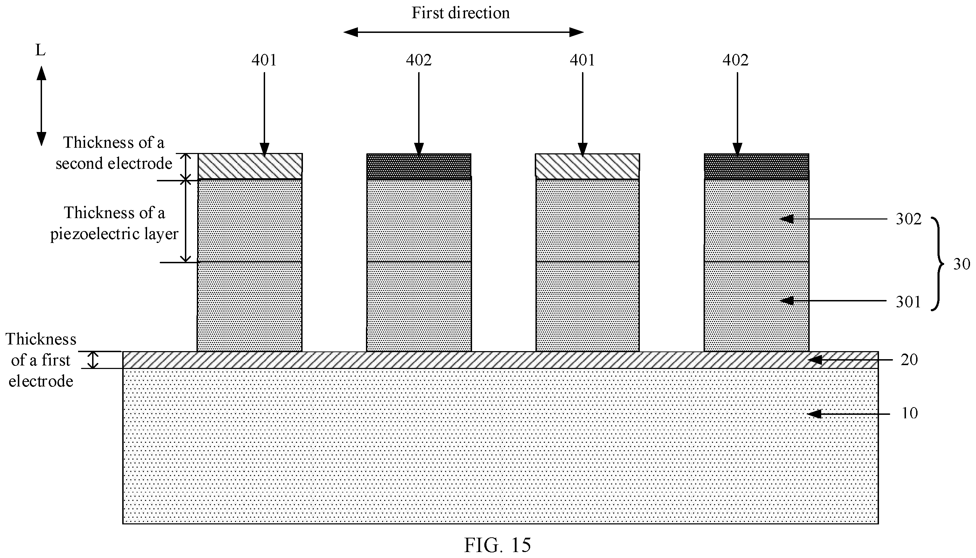

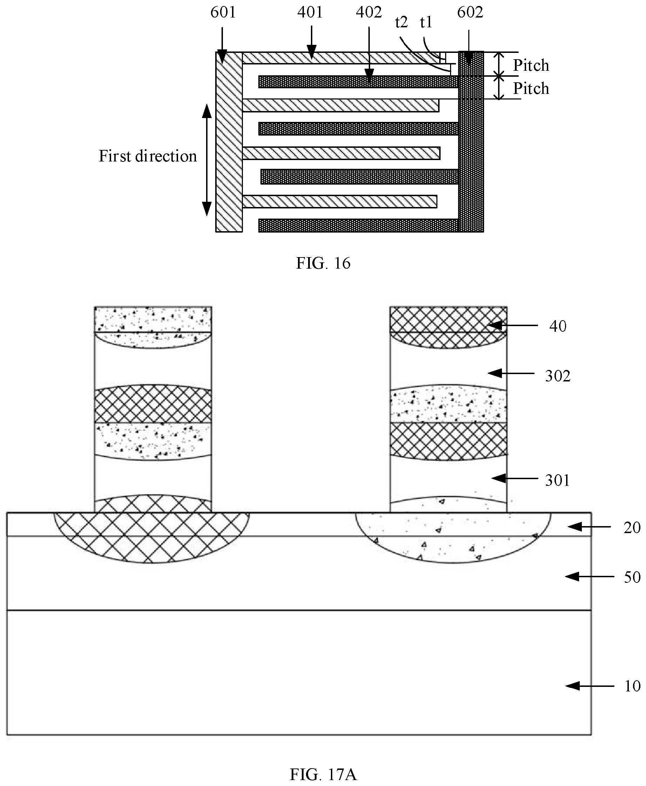

FIG. 15 is a diagram of a process structure of a resonator according to an embodiment of this application, and FIG. 16 is a diagram of distribution of second electrodes in FIG. 15.

In the resonators shown in FIG. 15 and FIG. 16, the plurality of second electrodes include a plurality of first interdigital electrodes 401 and a plurality of second interdigital electrodes 402. For example, along a direction perpendicular to an extension direction of the first interdigital electrode 401, the plurality of first interdigital electrodes 401 and the plurality of second interdigital electrodes 402 may be disposed side by side, and the plurality of first interdigital electrodes 401 and the plurality of second interdigital electrodes 402 are spaced apart. To be specific, one second interdigital electrode 402 may be disposed between two adjacent first interdigital electrodes 401. Alternatively, the first interdigital electrode 401 and the second interdigital electrode 402 are spaced apart along the first direction, and the extension direction of the first interdigital electrode 401 and/or an extension direction of the second interdigital electrode 402 are/is perpendicular to the first direction.

The plurality of first interdigital electrodes 401 are connected through a first busbar 601, and the plurality of second interdigital electrodes 402 are connected through a second busbar 602. For example, the first busbar 601 and the second busbar 602 are arranged in parallel, and both the first busbar 601 and the second busbar 602 extend along a direction perpendicular to the extension direction of the first interdigital electrode 401 or the extension direction of the second interdigital electrode 402. As shown in FIG. 16, the first busbar 601 and the second busbar 602 extend along the first direction.

A pitch (Pitch) P may be understood as follows: As shown in FIG. 16, a width of each first interdigital electrode 401 is t1, a spacing between each pair of the first interdigital electrodes 401 and the second interdigital electrode 402 that are adjacent is t2, and the pitch (Pitch) P is a sum of the width t1 and the spacing t2.

In some examples, the width t1 of the plurality of first interdigital electrodes 401 has a process tolerance, and the spacing t2 between each first interdigital electrode 401 and each second interdigital electrode 402 that are adjacent also has a process tolerance.

The thickness of the piezoelectric layer, a thickness of the first electrode, and a thickness of the second electrode are a height of the piezoelectric layer, a height of the first electrode, and a height of the second electrode along a stacking direction (for example, an L direction in FIG. 15) of a plurality of film layer structures.

A width-to-pitch ratio is a ratio of the width t1 of the first interdigital electrode 401 to the pitch P, or a ratio of a width of the second interdigital electrode 402 to the pitch. In some examples, the width of the first interdigital electrode 401 is equal to the width of the second interdigital electrode 402.

When the resonator operates, an acoustic loss is generated at the electrode, and consequently, operation performance of the device is reduced. For example, in FIG. 15, an acoustic loss may be generated at the first electrode 20 or the second electrode 40. To reduce an acoustic loss of the electrode, in some examples, a thickness of the electrode may be reduced. However, when the thickness of the electrode is reduced, a power tolerance capability of the electrode is reduced, and a service life of the device is shortened.

In the resonator in the example of this application, a plurality of stacked piezoelectric layers are used, to increase a thickness of the entire piezoelectric layer, so that a ratio of a thickness of the electrode layer to the thickness of the entire piezoelectric layer can be reduced. A thick piezoelectric layer is used to reduce an acoustic loss in the electrode, so that a power tolerance capability of the electrode can be ensured.

In some examples, as shown in FIG. 15, a thickness of the second electrode layer 40 is S1, and a sum of a thickness of the first piezoelectric layer and a thickness of the second piezoelectric layer is S2, where $S1/_{S2} \le 0.35$. For example, $S1/_{S2} \le 0.3$, and for another example, $S1/_{S2} \le 0.2$. For another example, $S1/_{S2} \le 0.1$.

In some examples, a thickness of the first electrode is S3, and the sum of the thickness of the first piezoelectric layer and the thickness of the second piezoelectric layer is S2, where $S3/_{S2} \le 0.35$. For example, $S3/_{S2} \le 0.3$, for another example, $S3/_{S2} \le 0.2$, and for another example, $S3/_{S2} \le 0.1$.

To increase the resonance frequency of the resonator, in some examples, the pitch shown in FIG. 16 may be reduced. However, when the pitch is reduced, a challenge is present to photolithography. In this example of this application, the pitch P and the thickness of the piezoelectric transducer layer 30 may satisfy: P/d≥1.

In some examples, the resonance frequency of the resonator may be greater than or equal to 3.64 GHz, for example, may reach 4.34 GHz.

With reference to the accompanying drawings and table data, the following compares an electromechanical coupling factor of the resonator provided in embodiments of this application with an electromechanical coupling factor of a resonator in the related technology.

FIG. 17A is a diagram of a process structure of a resonator according to an embodiment of this application. FIG. 17A is used to show vibration along the direction 3.

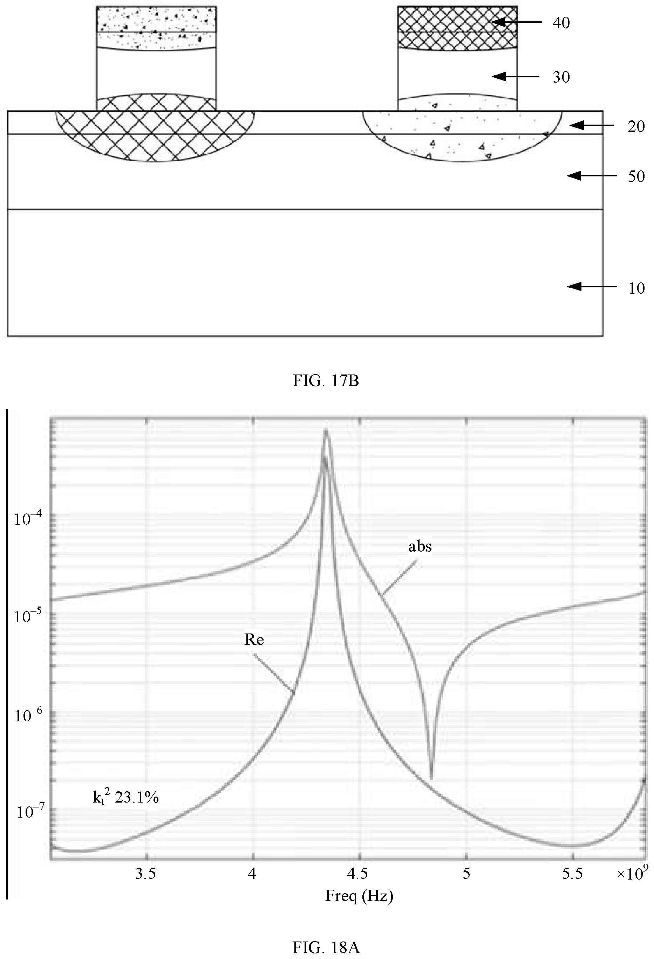

FIG. 17B is a diagram of a process structure of a resonator having one piezoelectric layer. FIG. 17B is used to show vibration along the direction 3.

In FIG. 17A and FIG. 17B, the groove is provided in the piezoelectric transducer layer, and the groove passes through the piezoelectric transducer layer.

As shown in FIG. 17A, vibration along the direction 3 exists at a position at which the second piezoelectric layer 302 is attached to the second electrode 401 and the second electrode 402, and vibration along the direction 3 exists at an interface between the second piezoelectric layer 302 and the first piezoelectric layer 301. In addition, slight vibration along the direction 3 exists at an interface between the first electrode 20 and the dielectric layer 50.

As shown in FIG. 17B, vibration along the direction 3 exists at a position at which the piezoelectric transducer layer 30 is attached to the second electrode 401 and the second electrode 402, and slight vibration along the direction 3 exists at an interface between the dielectric layer 50 and the first electrode 20. FIG. 17A is different from FIG. 17B in that, in FIG. 17A of an example of this application, coupling resonance is generated inside the entire piezoelectric layer.

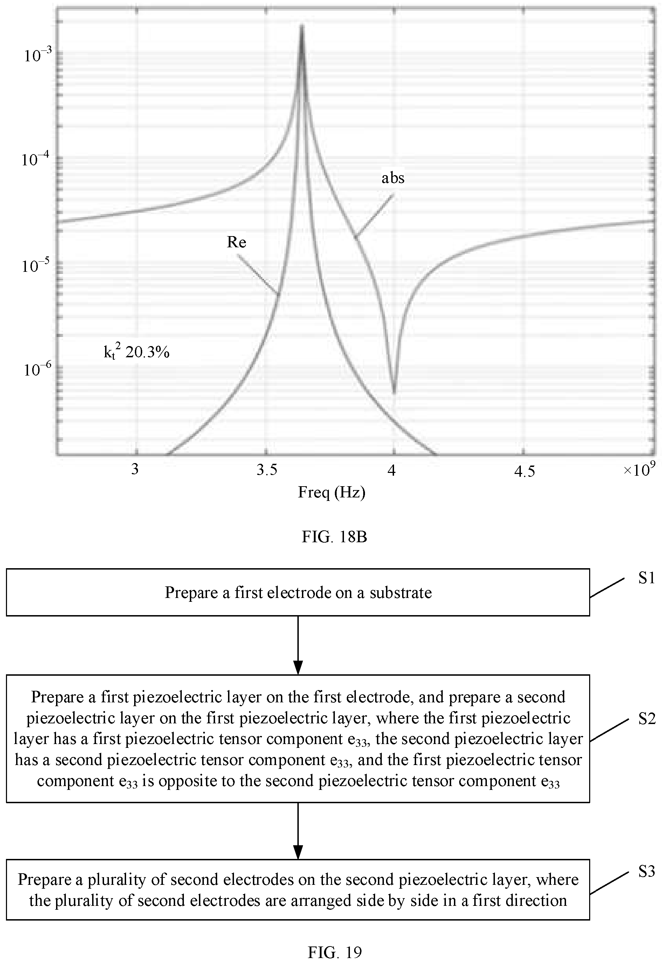

FIG. 18A is an admittance simulation curve obtained by using the structure in FIG. 17A and the physical parameter shown in Table 1 as limitations. FIG. 18B is an admittance simulation curve obtained by using the structure in FIG. 17B and the physical parameter shown in Table 2 as limitations.

Table 1

| Pitch: | 0.5 μm |
|---|---|
| Width-to-pitch ratio: | 0.5 |
| Thickness of the second electrode: | 90 nm |
| Thickness of the first piezoelectric layer: | 600 nm |
| Thickness of the second piezoelectric layer: | 600 nm |
| Mass fraction of Sc: | 40% |
| Thickness of the first electrode: | 90 nm |
| Thickness of the dielectric layer: | 300 nm |

Table 2

| Pitch: | 0.5 μm |
|---|---|
| Width-to-pitch ratio: | 0.5 |
| Thickness of the second electrode: | 90 nm |
| Thickness of the piezoelectric layer: | 600 nm |
| Mass fraction of Sc: | 40% |
| Thickness of the first electrode: | 90 nm |
| Thickness of the dielectric layer: | 300 nm |

The mass fraction of Sc in Table 1 and Table 2 is an example of this application. Materials of the first piezoelectric layer 301 and the second piezoelectric layer 302 may include AlScN, and the mass fraction of Sc may be 40%.

The physical parameters of the resonators of the two different structures in Table 1 and Table 2 are compared, and the pitches P are equal, the width-to-pitch ratios are equal, the thicknesses of the second electrode are equal, the thicknesses of the first electrode are equal, and the thicknesses of the dielectric layer are equal. Because one of the Euler angles of the materials of the two piezoelectric layers in Table 1 is rotated by 180° relative to the other of the Euler angles of the materials of the two piezoelectric layers in Table 1, the piezoelectric polarization directions of the first piezoelectric layer and the second piezoelectric layer are opposite.

The admittance simulation curve in FIG. 18A and the admittance simulation curve in FIG. 18B each show a modulus (abs) and a real part (Re) of the admittance curve.

It can be learned through comparison between the admittance simulation curve in FIG. 18A and the admittance simulation curve in FIG. 18B that: when the resonator in FIG. 17A in the example of this application is used, the electromechanical coupling factor $Kt^2$ reaches 23.1%, and when one piezoelectric layer shown in FIG. 17B is used, the electromechanical coupling factor $Kt^2$ is 20.3%. Apparently, when the groove is provided in the piezoelectric layer and a plurality of piezoelectric layers with opposite polarities are included, the electromechanical coupling factor $Kt^2$ can be increased.

In some embodiments, the electromechanical coupling factor $Kt^2$ of the resonator in the example of this application may be greater than or equal to 23%. For example, the electromechanical coupling factor $Kt^2$ may be 25%, 30%, or even larger.

Still refer to FIG. 18A and FIG. 18B. There is basically no parasitic spurious mode. Therefore, according to the resonator including at least two piezoelectric layers in this example, the electromechanical coupling factor and the resonance frequency can be increased, and the parasitic spurious mode can be suppressed, to further optimize performance of the resonator.

An embodiment of this application further provides a preparation method for a resonator including a plurality of piezoelectric layers. FIG. 19 shows an example of a block flowchart of the preparation method for a resonator. The preparation method includes the following steps.

Step S1: Prepare a first electrode on a substrate.

The substrate in the example of this application may be a high-sound-speed substrate, for example, may be made of any one or a combination of a plurality of silicon carbide (SiC), diamond (diamond), or boron nitride (BN).

Step S2: Prepare a first piezoelectric layer on the first electrode, and prepare a second piezoelectric layer on the first piezoelectric layer, where the first piezoelectric layer has a first piezoelectric tensor component $e_{33}$, the second piezoelectric layer has a second piezoelectric tensor component $e_{33}$, and the first piezoelectric tensor component $e_{33}$ is opposite to the second piezoelectric tensor component $e_{33}$.

In some optional materials, materials of the first piezoelectric layer and the second piezoelectric layer may include AlScN.

When the first piezoelectric layer and the second piezoelectric layer are prepared, an epitaxial growth technology may be used, allowing for easy control of a polarization direction of the piezoelectric layer.

Step S3: Prepare a plurality of second electrodes on the second piezoelectric layer, where the plurality of second electrodes are arranged side by side in a first direction. The first direction may be perpendicular to a stacking direction of the plurality of piezoelectric layers.

The first electrode may be made of any possible conductive metal (including but not limited to Al, Cu, W, Mo, Ru, Pt, and the like), or may be made of conductive metal (including but not limited to W, Ru, Mo, Pt, and the like) with high acoustic impedance. The metal with high acoustic impedance helps increase an electromechanical coupling factor and a quality factor Q, and further improve use performance of the resonator.

The second electrode may be made of any possible conductive metal (including but not limited to Al, Cu, W, Mo, Ru, Pt, and the like). The first electrode 20 and the second electrode 40 may be made of same conductive metal or different conductive metal.

For example, the foregoing piezoelectric thin-film resonator with a solid substrate or suspended piezoelectric thin-film resonator with an air cavity may be used as a sensor, for example, may be a temperature sensor, a humidity sensor, or a pressure sensor. Alternatively, the resonator may be used for processing of various high-frequency signals at 100 MHz to 30 GHz or the like as a delay-line device.

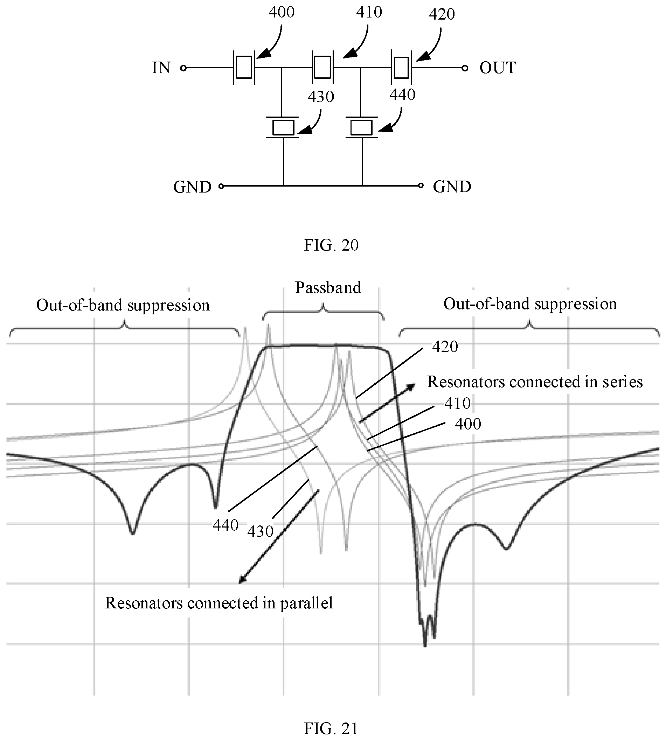

In addition, the foregoing suspended piezoelectric thin-film resonator with an air cavity or piezoelectric thin-film resonator with a solid substrate may be electrically connected in a trapezoidal structure shown in FIG. 20, to implement a filter for radio frequency communication. In the filter, there may be resonators connected in series with each other, or there may be resonators connected in parallel with each other. A resonance frequency of resonators connected in parallel may be less than a resonance frequency of resonators connected in series.

In an example in FIG. 20, a resonator 400, a resonator 410, a resonator 420, a resonator 430, and a resonator 440 are included. The resonator 400, the resonator 410, and the resonator 420 are resonators connected in series, and the resonator 430 and the resonator 440 are resonators connected in parallel. At least one of the resonator 400 to the resonator 440 may be the resonator in the foregoing embodiments.

In some examples, FIG. 21 shows a relationship between an admittance curve of each resonator in a trapezoidal filter in FIG. 20 and a transmission loss curve of the filter. As shown in FIG. 21, a resonance point of the resonators connected in series (for example, the resonator 400, the resonator 410, and the resonator 420) and an anti-resonance point of the resonators connected in parallel (for example, the resonator 430 and the resonator 440) fall within a passband frequency band, to form a passband of the filter. An anti-resonance point of the resonators connected in series (for example, the resonator 400, the resonator 410, and the resonator 420) falls on a high-frequency side outside the passband, and a resonance point of the resonators connected in parallel (for example, the resonator 430 and the resonator 440) falls on a low-frequency side outside the passband. In this way, the filter is characterized by high roll-off and high out-of-band suppression.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1.  A resonator, comprising:

    a substrate; and
    a first electrode, a piezoelectric transducer layer, and a plurality of second electrodes, wherein the first electrode, the piezoelectric transducer layer, and the plurality of second electrodes are disposed on the substrate, the piezoelectric transducer layer has a first side and a second side, the plurality of second electrodes are located on the first side and arranged side by side in a first direction, the first electrode is located on the second side, the first side faces away from the substrate, and the second side faces toward the substrate;
    the piezoelectric transducer layer comprises a first piezoelectric layer and a second piezoelectric layer that are stacked; and
    the first piezoelectric layer has a first piezoelectric tensor component $e_{33}$, the second piezoelectric layer has a second piezoelectric tensor component $e_{33}$, and the first piezoelectric tensor component $e_{33}$ is opposite to the second piezoelectric tensor component $e_{33}$.

2. The resonator according to claim 1, wherein a spacing is provided between two adjacent second electrodes; and a groove is provided at a position that is on the piezoelectric transducer layer and that is opposite to the spacing, and the groove penetrates with the spacing.

3. The resonator according to claim 2, wherein a thickness H of the piezoelectric transducer layer and a depth h of the groove satisfy: $30\%H \leq h \leq H$.

4. The resonator according to claim 2 or 3, wherein the first piezoelectric layer is disposed closer to the substrate than the second piezoelectric layer; and
the second piezoelectric layer has a top surface away from the first piezoelectric layer, the first piezoelectric layer has a bottom surface away from the second piezoelectric layer, and the groove passes through the top surface and the bottom surface.

5. The resonator according to any one of claims 1 to 4, wherein a thickness S1 of the second electrode and the thickness H of the piezoelectric transducer layer satisfy $S1/_H \leq 0.35$ .

6. The resonator according to any one of claims 1 to 5, wherein a thickness S2 of the first electrode and the thickness H of the piezoelectric transducer layer satisfy $S2/_H \leq 0.35$ .

7. The resonator according to any one of claims 1 to 6, wherein the resonator further comprises a first busbar and a second busbar;

in every two adjacent second electrodes in the plurality of second electrodes, one is a first interdigital electrode, the other is a second interdigital electrode, and the first interdigital electrode and the second interdigital electrode are spaced apart in the first direction;
a plurality of first interdigital electrodes in the plurality of second electrodes are connected through the first busbar, and a plurality of second interdigital electrodes in the plurality of second electrodes are connected through the second busbar;
a pitch P and the thickness H of the piezoelectric transducer layer satisfy: $P/H \geq 1$; and
a width of each first interdigital electrode is t1, a spacing between each pair of the first interdigital electrode and the second interdigital electrode that are adjacent is t2, the pitch P= t1+t2, and the width is a size in a direction parallel to a surface of the substrate and perpendicular to an extension direction of the first interdigital electrode.

8. The resonator according to any one of claims 1 to 7, wherein
by applying a voltage to the plurality of second electrodes, the resonator is configured to excite the piezoelectric transducer layer to generate a first resonance mode, and a vibration direction of the first resonance mode is perpendicular to the surface of the substrate.

9. The resonator according to any one of claims 1 to 8, wherein an electromechanical coupling factor $Kt^2$ of the resonator $\geq 23\%$.

10. The resonator according to any one of claims 1 to 9, wherein a material of the piezoelectric transducer layer comprises a combination of nitrogen, scandium, and aluminum, and a mass fraction of the scandium is greater than or equal to 10%; or
the material of the piezoelectric transducer layer comprises a combination of zinc and oxygen.

11. The resonator according to any one of claims 1 to 10, wherein the first electrode a first surface and a second surface that face away from each other, the second surface is closer to the substrate than the first surface, and the second surface of the first electrode is fully disposed on the substrate.

12. A filter, comprising:
a plurality of electrically connected resonators, wherein at least one of the plurality of resonators is the resonator according to any one of claims 1 to 11.

13. An electronic device, comprising:

an amplifier; and
the resonator according to any one of claims 1 to 11, or the filter according to claim 12, wherein the resonator or the filter is electrically connected to the amplifier.

Electronic device 100

Filter 200

Resonator 300

FIG. 1

500

600

800

60a 60b 60c 60d
60e
60f

900

70a 70b 70c 70d

700

FIG. 2

Filter 200

Resonator 300

FIG. 3

First
side

First direction

E

Region Q

Second
side

40

30

20

10

FIG. 4

40

First
surface

302
} 30
301

20

Second
surface

10

FIG. 5

FIG. 6

FIG. 7

FIG. 8

FIG. 9

Gap

70

40

302

30

301

20

50

10

FIG. 10

Gap

70

40

302

30

301

20

50

10

h

α α

FIG. 11

Gap

70

40

302 }
30
301 }

20

50

10

FIG. 12

401

402

30

20

10

FIG. 13

401    402

302

301

20

50

10

FIG. 14

First direction

L

401    402    401    402

Thickness of a
second electrode

Thickness of a
piezoelectric layer

302
30
301

Thickness
of a first
electrode

20

10

FIG. 15

601　　　401　　　402　　t2　t1　　602

Pitch

Pitch

First direction

FIG. 16

40

302

301

20

50

10

FIG. 17A

FIG. 17B

$k_t^2$ 23.1%

FIG. 18A

$k_t^2$ 20.3%

FIG. 18B

| | |
|---|---|
| Prepare a first electrode on a substrate | S1 |

Prepare a first piezoelectric layer on the first electrode, and prepare a second piezoelectric layer on the first piezoelectric layer, where the first piezoelectric layer has a first piezoelectric tensor component $e_{33}$, the second piezoelectric layer has a second piezoelectric tensor component $e_{33}$, and the first piezoelectric tensor component $e_{33}$ is opposite to the second piezoelectric tensor component $e_{33}$ — S2

Prepare a plurality of second electrodes on the second piezoelectric layer, where the plurality of second electrodes are arranged side by side in a first direction — S3

FIG. 19

400   410   420

IN o———[ ]———[ ]———[ ]———o OUT

430   440

GND o—————————————o GND

FIG. 20

Passband

Out-of-band suppression          Out-of-band suppression

420

Resonators connected in series

410

400

440  430

Resonators connected in parallel

FIG. 21

## INTERNATIONAL SEARCH REPORT

| International application No. |
| --- |
| **PCT/CN2024/116089** |

### A. CLASSIFICATION OF SUBJECT MATTER

H03H9/17(2006.01)i

According to International Patent Classification (IPC) or to both national classification and IPC

### B. FIELDS SEARCHED

Minimum documentation searched (classification system followed by classification symbols)

IPC: H03H

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 谐振器, 压电层, 多层, 两层, 压电张量分量, 相反, 机电耦合系数, resonator, piezoelectric layer, multi, two, piezoelectric tensor components, opposite, piezoelectric coupling factor

### C. DOCUMENTS CONSIDERED TO BE RELEVANT

| Category* | Citation of document, with indication, where appropriate, of the relevant passages | Relevant to claim No. |
| --- | --- | --- |
| A | CN 116131805 A (SUZHOU MEMSONICS TECHNOLOGIES CO., LTD.) 16 May 2023 (2023-05-16) description, paragraphs 0031-0050, and figures 1-5 | 1-13 |
| A | CN 114978089 A (WUHAN MEMSONICS TECHNOLOGIES CO., LTD.) 30 August 2022 (2022-08-30) entire document | 1-13 |
| A | CN 116155226 A (JWL (ZHEJIANG) SEMICONDUCTOR CO., LTD.) 23 May 2023 (2023-05-23) entire document | 1-13 |
| A | US 2020083862 A1 (VTT TECHNICAL RESEARCH CENTRE OF FINLAND LTD.) 12 March 2020 (2020-03-12) entire document | 1-13 |
| A | US 2023275563 A1 (SIWARD TECHNOLOGY CO., LTD.) 31 August 2023 (2023-08-31) entire document | 1-13 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **05 November 2024** | **11 November 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2024/116089**

| Patent document cited in search report | | | Publication date (day/month/year) | Patent family member(s) | | | Publication date (day/month/year) |
|---|---|---|---|---|---|---|---|
| CN | 116131805 | A | 16 May 2023 | None | | | |
| CN | 114978089 | A | 30 August 2022 | None | | | |
| CN | 116155226 | A | 23 May 2023 | WO | 2024108710 | A1 | 30 May 2024 |
| | | | | KR | 20240079190 | A | 04 June 2024 |
| | | | | EP | 4401311 | A1 | 17 July 2024 |
| US | 2020083862 | A1 | 12 March 2020 | US | 2022216852 | A1 | 07 July 2022 |
| | | | | EP | 3847748 | A1 | 14 July 2021 |
| | | | | JP | 2021536720 | A | 27 December 2021 |
| | | | | US | 2021075401 | A1 | 11 March 2021 |
| | | | | WO | 2020049170 | A1 | 12 March 2020 |
| | | | | CN | 112673568 | A | 16 April 2021 |
| US | 2023275563 | A1 | 31 August 2023 | None | | | |

Form PCT/ISA/210 (patent family annex) (July 2022)

# EP 4 749 919 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202311537342